Europäisches Patentamt

European Patent Office

Office européen des brevets

(11) Publication number: **0 067 393**
**B1**

(12) **EUROPEAN PATENT SPECIFICATION**

(45) Date of publication of patent specification: **28.05.86**

(21) Application number: **82104963.2**

(22) Date of filing: **07.06.82**

(51) Int. Cl.⁴: **H 01 L 27/08,** H 01 L 29/86, H 01 L 29/06

(54) **Semiconductor device having a resistor region with an enhanced breakdown voltage.**

(30) Priority: **05.06.81 JP 86586/81**

(43) Date of publication of application:
**22.12.82 Bulletin 82/51**

(45) Publication of the grant of the patent:
**28.05.86 Bulletin 86/22**

(84) Designated Contracting States:
**DE FR GB**

(56) References cited:
**EP-A-0 013 340**
**DE-A-1 953 171**
**GB-A-1 358 275**
**GB-A-1 434 441**
**US-A-3 538 398**
**US-A-3 959 812**

**Proceedings of the IEEE, Dec. 1964 pp. 1491-
1495, "Lateral complementary Transistor..." by
H.C. Lin et al.**

(73) Proprietor: **NEC CORPORATION**
**33-1, Shiba 5-chome, Minato-ku**
**Tokyo 108 (JP)**

(72) Inventor: **Fuse, Mamoru**
**c/o Nippon Electric Co., Ltd 33-1,**
**Shiba Gochome**
**Minato-ku Tokyo (JP)**

(74) Representative: **Glawe, Delfs, Moll & Partner**
**Patentanwälte**
**Postfach 26 01 62 Liebherrstrasse 20**
**D-8000 München 26 (DE)**

Courier Press, Leamington Spa, England.

## Description

Background of the invention

The present invention relates to a semiconductor device, and more particularly to a configuration of a resistor region in a high voltage monolithic IC (Intergrated Circuit).

A resistor in a bipolar or MOS-type monolithic IC is constructed by an elongated resistor region of one conductivity type formed in a semiconductor region of opposite conductivity type and electrodes provided on the both ends of the resistor region. A resistance value of the resistor is determined by the sheet resistance, width and length of the resistor region. In order to decrease manufacturing steps, the doping of impurities for forming the resistor region is usually effected simultaneously with doping of impurities for forming regions of transistors or other elements. In such case, the sheet resistance of the resistor region cannot be determined independently, and therefore, a desired resistance value is determined by the width and length of the resistor region.

In a pattern layout of a integrated circuit including resistors and other circuit elements, the resistor region is often defined not in a straight shape but in a bent shape. This is particularly true where the length of the resistor region is required to be long for a high resistance. Furthermore, the electrode contact regions at the both ends of the resistor region are formed in a square shape that is wider than the resistor region. The bent portion of the resistor region necessarily has corners and the electrode contact regions at the both ends have four corners, respectively.

The resistor region is isolated from the semiconductor region by applying such a potential to the semiconductor layer that a PN-junction formed between the resistor region and the semiconductor region be back-biased. Where the semiconductor region is of N-type, a positive potential is applied to the semiconductor region, whereas a negative potential is applied to the semiconductor region where it is of P-type. In order that the resistor region be isolated from the semiconductor region regardless of the signal voltage applied to the resistor region, the highest potential or the lowest potential (normally a power supply voltage) used in the monolithic IC is applied to the semiconductor region depending upon its conductivity type. Accordingly, when a voltage of the opposite polarity to the power supply voltage applied to the semiconductor region or a voltage near the opposite polarity power supply voltage is applied to one end of the resistor region, an intense back-bias voltage is applied between the resistor region and the semiconductor region. Further, in a monolithic IC, such as a high power amplifier, supplied with a power supply voltage of 100 V or higher, the back-bias voltage between the resistor region and the semiconductor region becomes more intense.

In the PN-junction formed between the resistor region and the semiconductor region, a straight PN-junction portion as viewed in a plan would be subjected to the avalanche breakdown even upon the application of the intense back-bias voltage. In other words, it has a high breakdown voltage. However, at the four convex corners of the electrode contact regions of the resistor region and at the convex corner in the bent portion of the resistor region, an electric field is concentrated, because the space charge region of the PN-junction is very thin there. The electric field concentration at the convex corner is more remarkable as the radius of curvature of the convex corner becomes less and as the back-bias voltage becomes larger. For this reason, the avalanche breakdown would occur firstly at the convex corners. Consequently, a breakdown voltage of the resistor region is determined by the breakdown voltage at the convex corner, which is a bar against a high voltage monolithic IC.

It should be noted that the breakdown voltage at the inside concave corner is far higher than that at the outside convex corner and may be higher than that at the straight portion of a PN-junction. This is because the space charge region is thicker there and the electric field is not concentrated. Both the concave corner and convex corner are associated with a pair of straight PN-junctions. The space charge region usually extends on the side of the semiconductor region in which the resistor region is formed. The space charge regions of a pair of straight PN-junctions associated with the concave corner are easily contacted with each other to form a thick space charge region at the concave corner, therefore where the electric field is hardly concentrated. In contrast, the space charge regions of a pair of the straight PN-junction associated with the convex corner are hardly contacted to each other, and therefore the space charge at the convex corner is very thin. Accordingly, the electric field is concentrated at the convex corner, resulting in a decreased breakdown voltage.

For the purpose of preventing such lowering of a breakdown voltage, various approaches have been proposed. However, even with any of the proposed approaches, a breakdown voltage could not be enhanced to a satisfactory extent, or instead, other shortcomings were brought about such as increase in steps in a manufacturing process and enlargement of an area occupied by the resistor region on a semiconductor chip.

A semiconductor device having an elongated, bent resistor region forming convex corners, as described above, has been known in the art, e.g. from PROCEEDINGS OF THE IEEE, December 1964, p.1495, and has been acknowledged in the pre-characterizing portion of claim 1.

It is an object of the invention to provide a semiconductor device of this type which has an improved breakdown voltage along said resistor region, including the convex corners thereof, without increasing the area occupied by said resistor region.

According to the invention this object is solved by the semiconductor device as defined in claim 1. Preferred embodiments are described in the dependent claims.

From US—A—3 538 398 there has been known a semiconductor device having a first region of a first conductivity type formed in a second region of opposite conductivity type, and one or more guard regions of said first conductivity type located adjacent and spaced from portions of the first region which in operation would be most susceptible to surface breakdown, such as the convex corners thereof. However, in this prior art device the first region is not an elongated resistor region which in operation will have a voltage drop, but a substantially square, polygonal or circular region which in operation will have a uniform potential. Therefore, the space charge regions extends substantially uniformly over the periphery of the first semiconductor region and those extending from two sides joining at a convex corner will reach the additional region or guard region at the same time.

In contrast thereto, according to the invention, the voltage drop existing along the resistor region will cause the two straight portions of the resistor region joined by a convex corner to have different reverse-bias relative to the semiconductor layer, and therefore the space charge region extending from one of said straight portions will be broader than that extending from the other one and will reach the corresponding leg of the additional region or guard region first. At this time the additional region will assume a potential corresponding to that of said one straight resistor portion having the higher reverse-bias, and a potential difference will exist between the additional region and the other one of said straight portions, which potential difference will be very effective in broadening the space charge region extending from said other straight portion, too, thereby improving the breakdown voltage at the convex corner very efficiently.

Other objects, features and advantages of the present invention will become more apparent by reference to the following detailed description taking in conjunction with the accompanying drawings, wherein:

Fig. 1 is a plan view showing a resistor region in a monolithic bipolar IC according to the prior art.

Fig. 2 is a plan view showing a resistor region provided according to a countermeasure proposed in the prior art for enhancing a breakdown voltage.

Fig. 3 is a plan view showing a resistor region provided according to another countermeasure proposed in the prior art for enhancing a breakdown voltage.

Fig. 4 is a plan view showing a resistor region according to a first preferred embodiment of the present invention.

Fig. 5 is a cross-section view taken along line A-A' in Fig. 4.

Fig. 6 is a plan view showing a resistor region according to a second preferred embodiment of the present invention.

Fig. 7 is a cross-section view taken along line B-B' in Fig. 6.

Detailed description of the prior art

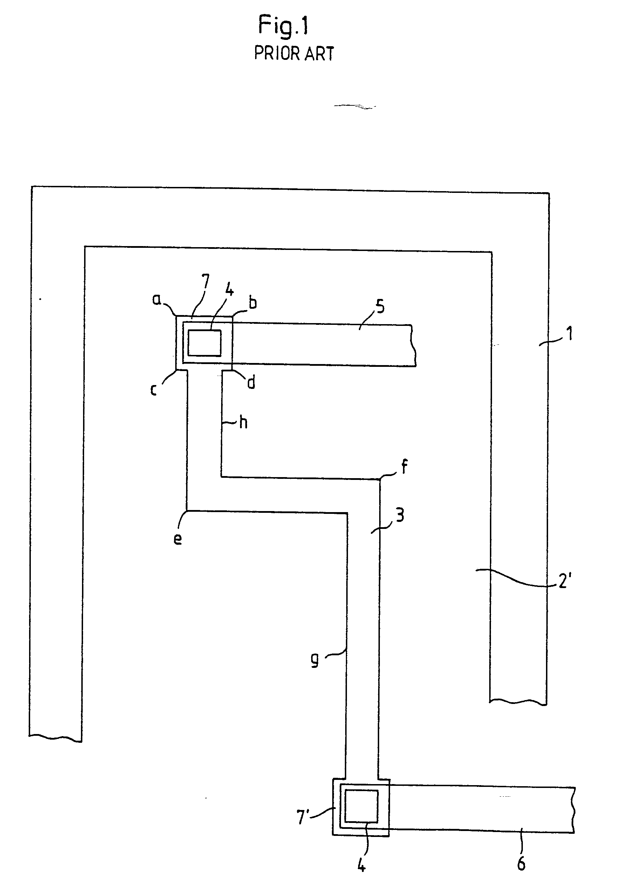

Referring now to Fig. 1, description will be made on a resistor region in a monolithic bipolar IC according to the prior art. An N-type epitaxial layer 2 formed on a P-type semiconductor substrate (not shown) is isolated into a plurality of island regions 2' by an isolation region 1. In one island region is formed a resistor region 3 by diffusing P-type impurities simultaneously with the formation of a base region of an NPN transistor. The resistor region 3 is bent twice substantially at a right angle by requirements of a pattern layout and its resistor length. In addition, at the both ends of the resistor region 3 are formed electrode contact regions 7 and 7', respectively, of a square shape that is broader than the width of the resistor region 3 in order to connect electrode wirings 5 and 6 of aluminum or the like. Hence, in the illustrated example, the resistor region 3 has two convex corners between the electrode contact regions 7 and 7', and each of the electrode contact regions 7 and 7' has four corners.

Contact windows 4 are opened in the surface insulating films on the electrode contact regions 7 and 7', and the electrode wirings 5 and 6 make contact with the electrode contact regions 7 and 7' through the windows 4, respectively. In order to seperate the resistor region 3 from the island region 2', the island region 2' of N-type is biased by the highest potential used in the IC having the resistance region 3, that is, by the positive power supply voltage. The electrode 5 is applied with the lowest potential used in the IC, that is, the ground potential or the negative power supply voltage, while the electrode 6 is applied with a signal voltage. Accordingly, the PN-junction between the N-type island region 2' and the P-type regions consisting of the portion of the resistor region 3 near to the electrode 5 and the electrode contact region 7 is intensely back-biased by a voltage close to the power supply voltage. Since the other electrode contact region 7' is applied with the signal voltage, the back-bias voltage applied across the PN-junction at the region 7' is not so intense.

The impurity concentration in the resistor region 3 and the electrode contact region 7 is higher than that in the island region 2'. Therefore, the space charge region from the PN-junction formed between these regions would expand principally on the side of the island region 2'.

The radius of convature at straight PN-junction portions $g$ and $h$ is infinite, whereas that at the convex corners $a$ to $f$ is extremely small. Therefore, the space charge region of the straight PN-junction portions $g$ and $h$ is considerably thicker than that of the convex corners $a$ to $f$.

For this reason, the concentration of an electric field to the convex corners $a$ to $f$ would arise. As a result, the avalanche breakdown would occur at these convex corners $a$ to $f$ earlier than at the straight PN-junction portions $g$ and $h$. In other words, a breakdown voltage of the resistor region 3 is determined by a breakdown voltage at its convex corners. This implies that a breakdown voltage of a monolithic IC having the resistor region is determined by convex corners of the resistor region. Though the other electrode contact region 7' also has corners, the back-bias voltage across the PN-junction at these corners of the region 7' is not so intense as described above. Therefore, the lowering of the breakdown voltage at the convex corners of the region 7' would not come into question.

In order to prevent the lowering of the breakdown voltage at the convex corner, three countermeasures described hereinafter have been adopted. One of the countermeasures is to form deeply the P-type regions for the resistor region 3 and the electrode contact regions 7 and 7'. However, the resistor region 3 is ordinarily formed simultaneously with other regions such as base regions of NPN transistors, and therefore, base regions also becomes deeper. Consequently, not only deterioration of a high frequency characteristic of the transistor is brought about, but also increase in an element area is resulted. Forming base region and the resistor regions in seperate steps would not raise the above problem, but the manufacturing steps are increased.

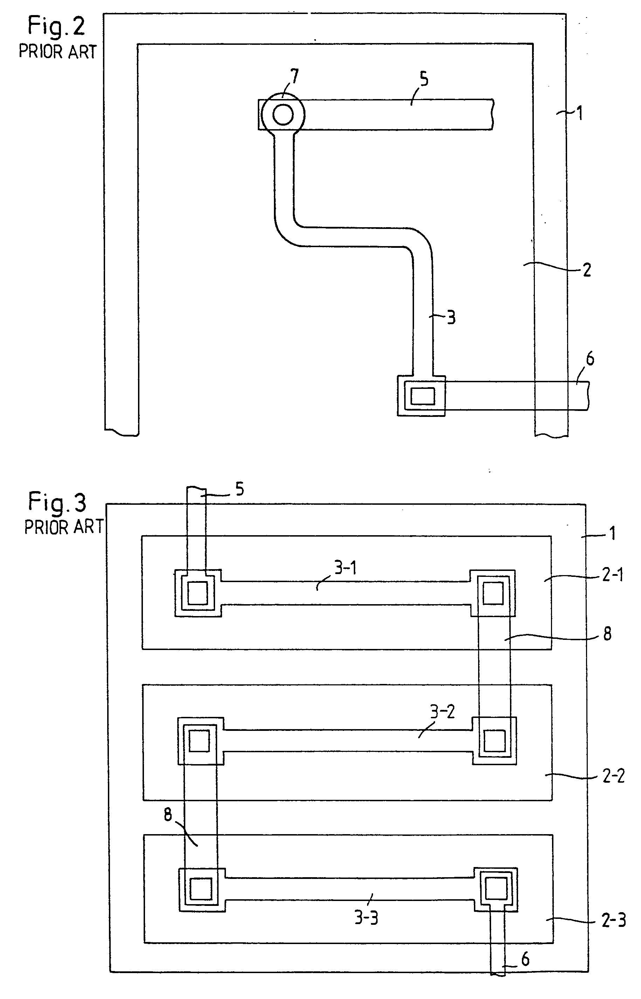

A second countermeasure is to round the convex corners a to f of the PN-junction to increase their radii of curvature, as shown in Fig. 2. However, it is complicated to calculate resistance values at the contact region 7 and at the rounded convex corners of the resistor regions 3. Moreover, it is difficult to form convex corners having smooth curvatures. Therefore, this countermeasure is not favorable.

A third countermeasure is to divide the resistor region 3 into a plurality of partial resistor regions for example, three resistor regions 3—1, 3—2 and 3—3, as shown in Fig. 3. The resistor region 3—1, 3—2 and 3—3 are formed in the island regions 2—1, 2—2 and 2—3 isolated by the isolation region 1, respectively, and are connected in series through interconnection conductors 8. The island regions 2—1, 2—2 and 2—3 are not supplied with any bias voltage. In other words, these regions 2—1, 2—2 and 2—3 are held in a floating conditions, respectively. Therefore, the reverse-bias voltages across the respective P-N junctions between the resistor regions 3—1, 3—2 and 3—3 and the island regions 2—1, 2—2 and 2—3 are reduced to 1/3 $V_{cc}$ ($V_{cc}$ being a power supply voltage). However, the occupation area of the resistor by this countermeasure is increased, and further a freedom in pattern layout is lost.

Detailed description of the preferred embodiments

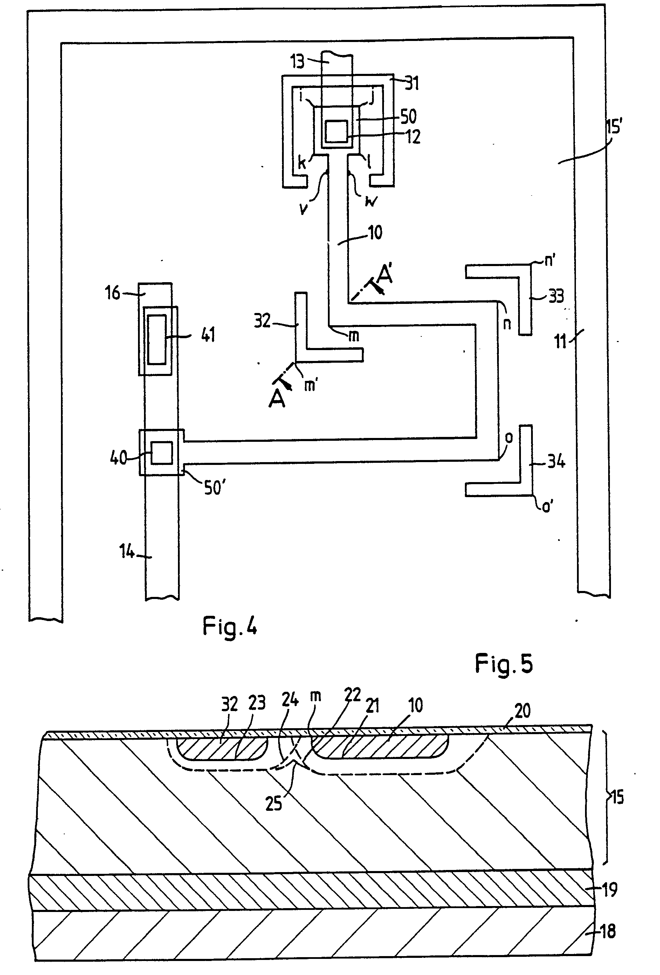

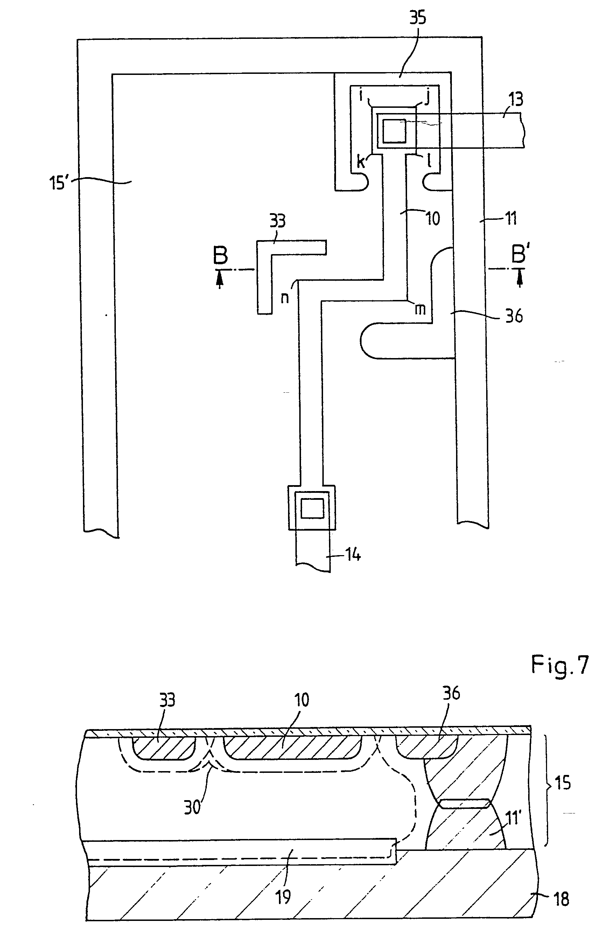

Referring now to Figs. 4 and 5, a first preferred embodiment of the present invention will be described. An N-type epitaxial layer 15 is formed on a P-type substrate 18 in which an N-type buried region 19 and a P-type buried region (not shown) serving as an insulation region are selectively formed. The N-type epitaxial layer 15 has a resistivity of 10 to 15 Ω-cm and a thickness of 25.7 to 29.0 μm. A P-type impurity is introduced into the epitaxial layer 15 to form a P-type isolation region 11 having a sheet resistance of 7.5Ω/– and a depth of 20 μm. The isolation region 11 is connected to the P-type buried region formed in the substrate 18. Consequently, the isolation region 11 isolates the epitaxial layer 15 into a plurality of island regions. A P-type impurity is introduced into one island region 15' simultaneously with the formation of a base of an NPN transistor in order to form a resistor region 10 having a sheet resistance of 250Ω/– and a depth of 3.0 μm. Electrode contact regions 50 and 50' are provided at the both ends of the resistor region 10, respectively. It is to be noted that the resistor region 10 is bent three times at a right angle between the electrode contact regions 50 and 50' in order to obtain the required resistor length. Therefore, the resistor region 10 has three convex corners m, n, and o. The electrode contact region 50 has four convex corners i, j, k, and l, and the other electrode contact region 50' also has four convex corners, Though these convex corners i to o are formed at a right angle on a mask pattern, they have some roundness in practice due to the lateral expansion of impurities. However, their radii of conveture are extremely small.

An aluminum conductor 13 is provided on the electrode contact region 50 through a contact window 12 formed by selectively removing a surface insulating film 20. The conductor 13 is supplied with a potential of 1V. An aluminum conductor 14 is connected to the other electrode contact region 50' via a contact window 40. The conductor 14 is supplied with a power supply voltage $V_{c\ c}$ of 100 V. Since the conductor 14 is supplied with a power supply voltage $V_{cc}$, it is further connected via a contact window 41 to a high concentration region 16 of the same N-type as the island region 15' in order to bias the region 15'. Accordingly, the back-bias voltage applied across the PN-junction in the electrode contact region 50' is small, but the PN-junctions in the electrode contact region 50 and in the resistor region 10 close to this region 50 are held in an intensely back-biased condition.

For the purpose of enhancing breakdown voltages at the convex corners of the P-type regions 10 and 50, additional P-type regions 31 to 34 are formed in the island region 15'. The regions 31 to 34 are juxtaposed with the convex corners i or l and the convex corners m to o with the distance from the convex corners i to o being selected such that the space charge region (depletion layer) expanding from a straight PN-junction portion associated with the convex corners of the resistor regions 10 can reach the respective regions 31 to 34. In other words, the distances are shorter than the lengths of the space charge regions expanding from the straight PN-junction portions when the convex corners i to o are subjected to the avalanche breakdown. The P-type region 31 disposed against the convex corners i to l of the

contact region 50 is formed to integrally enclose the contact region 50, while the P-type region 32 to 34 are disposed outside the respective convex corners $m$ to $o$ with the similar corners $m'$ to $o'$. These P-type regions 31 to 34 are formed simultaneously with the formation of the resistor region 10 and the contact regions 50 and 50', and are held in a floating condition without being applied with any voltage.

Referring also to Fig. 5, when a power supply is switched on for starting a circuit operation, a space charge region (depletion layer) 22 extends from a PN-junction 21 between the resistor region 10 and the island region 15' towards the side of the epitaxial layer 15. The extent of the space charge region 22 becomes larger as the power supply voltage $V_{cc}$ is increased. The distance between the region 32 and the convex corner $m$ of the resistor region 10 is selected to be such that the space charge region expanding from the straight PN-junction portion associated with the convex corner $m$ can reach the region 32 and the space charge region from the region 32 can reach the space charge region from the convex corner $m$. Therefore, the space charge region (not shown in Fig. 5) from the straight portion in plan view of a PN-junction near the convex corner $m$ reaches the P-type region 32 before the breakdown occurs at the convex corner m. Then, the potential of the space charge region is applied to the region 32. As a result, a PN-junction 23 between the P-type region 32 and the N-type island region 15' is also back-bias, so that a space charge region 24 of this PN-junction 23 expands from the region 32 towards the island region 15'. The space charge region 24 from the concave corner of the region 32 expands more widely and contacts the space charge region 22 from the convex corner $m$ which is thinner than that from the straight PN-junction portion. Accordingly the overall space charge region extending from the convex corner $m$ is a composite region 25 which is addition of the space charge regions 22 and 24. In other words, owing to the effect of the P-type region 32 juxtaposed along the convex corner $m$ of the resistor region 10, the space charge region expanding from the convex corner $m$ is elongated far beyond the thin space charge region from the corner $m$ in the case where the region 32 is not present. Therefore, the electric field concentration at the convex corner $m$ is widely mitigated, so that its breakdown voltage is enhanced. Likewise, the breakdown voltages at the other convex corners $i$ to $l$, $n$ and $o$ are also increased by the regions 31, 33, and 34.

The distance between the region 31, 32, 33 or 34 and the convex corner of the resistor region 10 can take any value subject to not exceeding such a distance that the space charge region from the straight PN-junction portion reaches the regions 31 to 34 before the avalanche breakdown occurs at the convex corner. However, if the selected distance is close to the length of the space charge region just before the occurrence of the avalanche breakdown, the space charge region from the straight PN-junction can at last reach the P-type region 32 to 34 just prior to the occurrance of the avalanche breakdown. For this reason, the effect of extending the space charge region at the convex corner by means of the P-type regions 31 to 34 is small. On the other hand, if the selected distance is too short, the space charge region extending from the straight PN-junction portion would immediately reach the P-type region 17. Therefore, the effect of extending the space charge region is also small. From the above-mentioned viewpoints, it is favorable that the distance between the P-type regions 31 to 34, and the convex corner of the resistor region 10 is selected to be 1/3 to 2/3 times as small as the distance of he space charge region expanding from the convex corner at the maximum in the case where the P-type regions 31 to 34 are not provided. The distance of the space charge region expanding at the maximum is varied by the back-bias voltage across the PN-junction, the resistivity of the island region 15', and the like. In the illustrated embodiment, the voltage applied to the island region 15 is 100 V and the resistivity of the island region 15 is 10 to 15 $\Omega$-cm and therefore, a distance of 10 $\mu$m was selected as the distance between the corner and the regions 31 to 34. This distance is equivalent to about 1/2 of the above-described maximum distance. Owing to the formation of the P-type regions 31 to 34, a breakdown voltage of the resistor region 10 of about 120 V was obtained under the above-mentioned conditions. In the case where the regions 31 to 34 are not present, the breakdown voltage was 90 to 100 V and hence, a power supply voltage of 100 V could not be applied to the monolithic IC including the resistor region 10. In other words, an enhancement of a breakdown voltage of 20 to 30 V was realized.

The region 31 opposed to the convex corners $i$ to $l$ may be omitted by forming the contact region 50 in such a shape as described below. The convex corner $i$ and $j$ do not directly contribute to the resistance value of the resistor. Therefore, the convex corner $i$ and $j$ may be formed roundly to obtain a large radius of curveture. On the other hand, the convex corners $k$ and $l$ have the influence on the resistance value, and therefore, they cannot be made round. However, the space charge regions from the convex corners $k$ and $l$ can be further extended by the space charge regions from the straight PN-junction portions $v$ and $w$ of the resistor region 10 near the contact region 50. This is because the width of the contact region 50 is slightly larger than that of the resistor region 10. Accordingly, the electric field concentration at the convex corners $k$ and $l$ is mitigated. In addition, by forming a contact region 50 having the same width as the resistor region 10, the convex corners $k$ and $l$ are not produced, Thus, the region 31 opposed to the convex corners $i$ to $l$ can be omitted by forming the contact region 50 in a specific space.

A second preferred embodiment of the present invention is illustrated in Figs. 6 and 7, in which parts similar to those shown in Figs. 4 and 5 are given with like reference numerals, and further description thereof will be omitted here. In this embodiment, a P-type buried layer 11' for forming an isolation region in cooperation with the region 11 is shown. The big difference between this preferred embodiment and the embodiment shown in Figs. 4 and 5 is in that P-type regions 35 and 36 provided for the purpose of mitigating the electric field concentration at the convex corners $i$ to $l$ and $m$ of the resistor region 10 are disposed in contact with the isolation region 11. This is caused by the fact that the resistor region 10 is disposed near to the insulator isolation layer 11. The effect of enhancing the breakdown voltage of the resistor region 10 having the illustrated structure will be readily understood by Fig. 7 which shows a cross-section taken along a line B-B' in Fig. 6. From Fig. 7, space charge region 30 from the resistor region 10 is elongated farther than the space charge region upon the avalanche breakdown. Furthermore, because of the fact that the P-type regions 35 and 36 make contact with the isolation region 11, the occupation area of the resistor element according to this embodiment can be made smaller than that according to the first preferred embodiment. It is to be noted that since the isolation layer 11 is biased at the lowest potential, the back-biasing voltage of $V_{cc}$ is applied between the P-type regions 35, 36 and 33 and the island region 15'. Therefore, in order to prevent the convex corners of the P-type regions 35 and 36 from being subjected to the avalanche breakdown due to the electric field concentration, they are rounded to reduce curvatures. In this case, the P-type region 35 and 36 is not a resistor region, and therefore, the problem arising upon rounding the convex corners of the resistor region 10, as described previously with reference to Fig. 2, does not occur.

Incidentally, one may consider that the punch-through phenomena would occur because the space charge region expanding from the resistor region 10 and that expanding from the P-type region 35 and 36 make contact with each other. However, the N-type island region 15 is biased by the power supply voltage $V_{cc}$. Therefore, so long as the space charge region expanding from the resistor region 10 does not arrive at the P-type regions 35 and 36 by overcoming the space charge regions extending from the P-type regions 35 and 36, the punch-through phenomena could not occur. Hence, there is no influence on the voltage applied to the resistance region 10.

As described in detail above, the present invention provides a great advantage of enhancing a breakdown voltage of a resistor element whose PN-junction is back-biased by a high voltage such as a power supply voltage. This advantage according to the present invention is attained without any increase in manufacturing steps, the complicated calculation of the resistance value and increase in the occupation area of the resistor region which have occurred in the prior arts.

Though the above embodiments show only one resistor region, respectively, the present invention can be also applied to a semiconductor device having two or more resistor regions formed in one island region. In this case, one P-type region for enhancing a breakdown voltage could be commonly used for a plurality of resistor regions. Furthermore, the present invention is equally applicable to IC's having the interchanged conductivity types of the respective regions, and also applicable to resistor regions in MOS-type IC's. Further, the configurations of the resistor regions and the regions provided for increasing a breakdown voltage are not limited to the illustrated shapes.

## Claims

1. A semiconductor device comprising a semiconductor layer (15) of one conductivity type, an isolation region (11) electrically separating said semiconductor layer into a plurality of island regions, and a resistor region (10) of the opposite conductivity type formed in one island region (15') and forming a P-N junction therewith,
said resistor region (10), in plan view, being elongated and bent at least once to form convex corner (m, n, o) joining two adjacent straight P-N junction portions (g, h) of said resistor region,
said one island region (15') being applied with a bias potential to reverse-bias said P-N junction of said resistor region (10)
and the end portions (50, 50') of said resistor region (10) being supplied, respectively, with a first potential and a second potential higher than the first potential so as to create a voltage drop along said resistor region (10),
said voltage drop causing the reverse-bias at one of said straight P-N junction portions to be higher than the reverse-bias at the other of said straight P-N junction portions, characterized in that there is provided at least one additional region (32, 33, 34) of said opposite conductivity type formed in said one island region (15') adjacent to said convex corner (m, n, o) and having two arms, each extending partially along the associated one of said straight P-N junction portions,
said additional region (32, 33, 34) being positioned at a distance from said convex corner (m, n, o) such that at least a portion of the space charge region extending from said one straight P-N junction portions having the higher reverse-bias reaches the associated arm of said additional region before an avalanche breakdown occurs at said convex corner.

2. A semiconductor device as claimed in claim 1, wherein said additional region (32, 33, 34) has the same junction depth as said resistor region (10).

3. A semiconductor device as claimed in claim 1, characterized in that said additional region (36) makes contact with said isolation region (11).

## Patentansprüche

1. Halbleiteranordnung mit einer Halbleiterschicht (15) von einem Leitfähigkeitstyp, einem Isolationsbereich (11), der die Halbleiterschicht elektrisch in eine Vielzahl von Inselbereichen aufteilt, und einem Widerstandsbereich (10) vom entgegengesetzten Leitfähigkeitstyp, der in einem Inselbereich (15') ausgebildet ist und damit einen P-N Übergang bildet, wobei der Widerstandsbereich (10) in Draufsicht langgestreckt ist und mindestens einmal geknickt ist, um eine konvexe Ecke (m, n, o) zu bilden, die zwei aneinanderliegende gerade P-N Übergangsbereiche (g, h) des Widerstandsbereiches verbindet,

wobei der eine Inselbereich (15') mit einem Vorspannpotential beaufschlagt wird, um den P-N Übergang des Widerstandsbereichs (10) in Sperrichtung vorzuspannen, und wobei die Endteile (50, 50') des Widerstandsbereiches (10) mit einem ersten Potential bzw. einem zweiten Potential, welches höher ist als das erste, beaufschlagt werden, so daß ein Spannungsabfall über den Widerstandsbereich (10) erzeugt wird, wobei der Spannungsabfall bewirkt, daß die Vorspannung in Sperrichtung bei einem der geraden P-N Übergangsbereiche höher ist als die Vorspannung in Sperrichtung beim anderen der geraden P-N Übergangsbereiche, dadurch gekennzeichnet, daß mindestens ein zusätzlicher Bereich (32, 33, 34) des entgegengesetzten Leitfähigkeitstypes vorgesehen ist, der in dem einen Inselbereich (15') in der Nähe der konvexen Ecke (m, n, o) ausgebildet ist und zwei Arme aufweist, die sich jeweils teilweise längs des zugehörigen einen geraden P-N Übergangsbereiches erstrecken,

wobei der zusätzliche Bereich (32, 33, 34) so von der konvexen Ecke (m, n, o) beabstandet ist, daß mindestens ein Teil des Raumladungsbereiches, der sich von dem einen geraden P-N Übergangsbereich mit der höheren Vorspannung in Sperrichtung erstreckt, den zugehörigen Arm des zusätzlichen Bereiches erreicht, bevor an der konvexen Ecke ein Lawinendurchschlag auftritt.

2. Halbleiteranordnung nach Anspruch 1, dadurch gekennzeichnet, daß der zusätzliche Bereich (32, 33, 34) die gleiche Übergangstiefe aufweist wie der Widerstandsbereich (10).

3. Halbleiteranordnung nach Anspruch 1, dadurch gekennzeichnet, daß der zusätzliche Bereich (36) einen Kontakt bildet mit dem Isolierbereich (11).

## Revendications

1. Dispositif semi-conducteur comprenant:
—une couche en semi-conducteur (15) d'un type de conductibilité;
—une région d'isolement (11) séparant électriquement la couche en semi-conducteur en une multitude de régions à île,
—et une région à résistance (10) du type de conductibilité opposé formée dans une région à île (15') et constituant une jonction P-N avec elle,
—la région résistante (10), dans une vue en plan, étant allongée et cambrée au moins une fois de manière à former un angle convexe (m, n, o) reliant deux portions de jonction P-N rectilignes contiguës (g, h) de la région à résistance,
—la région à île (15') étant soumise à un potentiel de polarisation de manière à polariser inversement la jonction P-N de la région à résistance (10),
—et les parties extrêmes (50, 50') de la région à résistance (10) étant soumises, respectivement, à un premier potentiel et à un second potentiel supérieur au premier potentiel de manière à créer une chute de tension dans la région à résistance (10),
—cette chute de tension ayant pour effet que la polarisation inverse de l'une des portions de jonction P-N rectilignes est supérieure à la polarisation inverse de l'autre des portions rectilignes de la jonction P-N, caractérisé en ce qu'on a prévu au moins une région supplémentaire (32, 33, 34) du type de conductibilité opposé qui est formée dans ladite région à île (15') contiguë à l'angle convexe (m, n, o) et ayant deux bras, s'étendant chacun partiellement suivant la portion associée des portions rectilignes de jonction P-N,
—la région supplémentaire (32, 33, 34) étant située à une certaine distance de l'angle convexe (m, n, o) de sorte qu'au moins une portion de la région des charges spatiales s'étendant à partir de ladite portion rectiligne de jonction P-N ayant la polarité inverse plus élevée atteint le bras associé de la région supplémentaire avant qu'un claquage par avalanche se produise à l'angle convexe.

2. Dispositif semi-conducteur selon la revendication 1, où la région supplèmentaire (32, 33, 34) a la même profondeur de jonction que la région à résistance (10).

3. Dispositif semi-conducteur selon la revendication 1, caractérisé en ce que la région supplémentaire (36) est en contact avec la région d'isolement (11).

Fig.1
PRIOR ART

Fig.2
PRIOR ART

Fig.3
PRIOR ART

Fig. 4

Fig. 5

Fig.7